(19) Europäisches Patentamt
European Patent Office
Office européen des brevets

(11) EP 3 163 462 A1

(12) DEMANDE DE BREVET EUROPEEN

(43) Date de publication:
03.05.2017 Bulletin 2017/18

(51) Int Cl.:
G06F 17/15 (2006.01)     G01R 33/36 (2006.01)

(21) Numéro de dépôt: 16196447.3

(22) Date de dépôt: 28.10.2016

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
MA MD

(30) Priorité: 29.10.2015 FR 1560391

(71) Demandeur: Université Grenoble Alpes
38400 Saint-Martin-d'Hères (FR)

(72) Inventeur: LAMALLE, Laurent
38000 GRENOBLE (FR)

(74) Mandataire: GIE Innovation Competence Group
310, avenue Berthelot
69372 Lyon Cedex 08 (FR)

(54) PROCÉDÉ D ESTIMATION D'UN PRODUIT DE CONVOLUTION

(57) L'invention est un procédé d'estimation d'un produit de convolution d'une fonction de mesure, représentant des mesures, définie selon des premières coordonnées, par un noyau de convolution.

Le produit de convolution est estimé à des deuxièmes coordonnées, différentes desdites premières coordonnées. La fonction de mesure représente des mesures effectuées à partir d'un détecteur, en particulier un détecteur de grandeurs physiques. Un exemple d'application du procédé concerne l'Imagerie par Résonance Magnétique, le procédé permettant une redistribution de données mesurées, non uniformément réparties, selon un maillage uniforme, préalablement à l'application d'un algorithme de transformée de Fourier rapide.

Fig. 2

EP 3 163 462 A1

**Description**

**DOMAINE TECHNIQUE**

Le domaine technique de l'invention est le traitement de données mesurées par un dispositif de mesure. Plus précisément, l'invention concerne un procédé d'interpolation d'une fonction représentant des mesures issues d'un détecteur. Une des applications visées est une répartition selon un maillage uniforme, de données mesurées préalablement à la réalisation d'une transformée de Fourier rapide.

**ART ANTERIEUR**

Le recours à une transformée de Fourier rapide est couramment utilisé pour transformer des données, définies dans un domaine spatial ou temporel, vers un domaine fréquentiel, et réciproquement.

Par exemple, dans le domaine de l'Imagerie par Résonance Magnétique (IRM), on acquiert des mesures, sous la forme de données radio-fréquentielles échantillonnées dans un espace de départ, assimilable au domaine des fréquences spatiales, cet espace étant désigné par le terme espace k. Les mesures sont échantillonnées selon des coordonnées $r_i = (k_{x,i}, k_{y,j})$ dans cet espace k. Au cours d'une acquisition, on applique un champ magnétique à un objet examiné, le gradient de ce champ magnétique, dit gradient de champ magnétique d'encodage spatial, étant modulé. La coordonnée $r_i$ de chaque mesure, échantillonnée dans l'espace k, correspond à l'intégrale, au cours du temps, du gradient de champ magnétique d'encodage spatial appliqué à l'objet examiné. Cette coordonnée est multidimensionnelle, et s'exprime généralement selon deux ou trois dimensions dans l'espace k. Les mesures correspondent à un signal électromagnétique, généralement dans le domaine des radiofréquences, mesuré par une antenne et représentatif d'une distribution spatiale de l'aimantation nucléaire dans l'objet examiné. Pour obtenir une information directement exploitable, on applique une transformée de Fourier multidimensionnelle, par exemple 2D, aux mesures, échantillonnées dans l'espace k, de façon à obtenir une image *I* de l'objet examiné, dans un espace dit d'arrivée, représentant le domaine spatial, parfois dénommé espace direct. L'image *I* est telle que

$$I(x) = \int_r f(r)\, e^{i2\pi xr} dr \approx \sum_{r_i} f(r_i) e^{i2\pi x r_i} \delta\, r_i$$

où x désigne une coordonnée multidimensionnelle dans l'espace d'arrivée, r désigne une coordonnée multidimensionnelle dans l'espace k, $f(r_i)$ désigne une mesure échantillonnée à la coordonnée $r_i$ dans l'espace k et $\delta r_i$ représente une aire élémentaire associée à ladite coordonnée $r_i$. Cette image *I* représente une distribution de l'aimantation nucléaire dans l'objet examiné. Dans ce texte, le symbole ≈ signifie « étant approximé par ».

Usuellement, cette transformée de Fourier est réalisée en mettant en oeuvre un algorithme de transformée de Fourier rapide, plus connu sous l'acronyme FFT (Fast Fourier Transform). Cependant, le recours à un tel algorithme suppose que les coordonnées, dans l'espace de départ, soient réparties de manière régulière, en définissant une grille cartésienne uniforme. Cette condition n'est pas forcément remplie, en particulier lorsque des mesures sont échantillonnées, dans l'espace k, selon des coordonnées $r_i$ réparties de façon pseudo-aléatoire ou suivant une trajectoire particulière, par exemple radiale, ou en spirale, en étant distribuées non régulièrement selon cette trajectoire. Du fait de la distribution non uniforme des mesures dans l'espace k, on ne peut pas utiliser directement un algorithme de transformée de Fourier rapide. Il est nécessaire de redistribuer les mesures selon une grille cartésienne uniforme. Une simple interpolation des mesures sur la base de leurs proches voisins ne donne pas un résultat satisfaisant. Aussi, il est courant de redistribuer, selon ladite grille cartésienne uniforme, non pas les mesures $f(r_i)$, mais un produit de convolution de ces mesures par un noyau de convolution g, ce dernier étant défini selon un support fini Ω. Le produit de convolution est calculé en chaque point $u_j$ de la grille cartésienne uniforme. Un noyau de convolution couramment utilisé est la fonction de Kaiser-Bessel, ou encore une fonction *sinc* tronquée. L'effet du noyau de convolution est compensé, après transformée de Fourier, par une "dé-apodisation", consistant à une division par une transformée de Fourier du noyau de convolution. Les étapes de convolution et de dé-apodisation sont couramment désignées par le terme anglais « gridding ». Un tel produit de convolution peut être déterminé en appliquant l'équation suivante :

$$f * g\,(u_j) = \sum_{r_i \in \Omega_j} f(r_i)\, g(u_j - r_i) \quad (1),$$

où :

- $r_i$ désigne des premières coordonnées, distribuées de manière non uniforme dans l'espace k, par exemple selon une trajectoire décrivant une spirale ;
- $u_j$ désigne des deuxièmes coordonnées (ou coordonnées d'interpolation) constituant la grille cartésienne uniforme, dans ledit espace k;
- $\Omega_j$ désigne le support du noyau de convolution (support de convolution) centré en $u_j$.

Lors du calcul du produit de convolution, les données mesurées $f(r_i)$ sont corrigées par une fonction $c$, dite densité d'échantillonnage, destinée à compenser la répartition non uniforme des coordonnées $r_i$ des mesures. Cette fonction $c$ peut être déterminée soit de manière analytique, soit par le biais d'un maillage géométrique de l'espace k, par exemple un maillage de Voronoï. On applique alors un facteur de pondération, représentant la densité d'échantillonnage, à chaque terme du produit de convolution, selon l'expression :

$$f * g\,(u_j) = \sum_{r_i \in \Omega_j} \frac{f(r_i)\,g(u_j - r_i)}{c(r_i)} \qquad (1')$$

La valeur de la fonction $c(r_i)$ à chaque coordonnée $r_i$ dépend de la densité d'échantillonnage autour de cette coordonnée, ou échantillon, $r_i$. Plus elle est élevée, plus l'échantillonnage est dense. Dans le cas où l'espace k est maillé selon un maillage de Voronoï, si $\delta(r_i)$ décrit l'aire d'une cellule de Voronoï correspondant à la coordonnée $r_i$, $\frac{1}{c(r_i)} \approx \delta(r_i)$.

Un tel produit de convolution est alors calculé en chaque coordonnée $u_j$ de la grille cartésienne uniforme. En lui appliquant une transformée de Fourier rapide, on obtient une image de l'objet examiné dans l'espace direct. Comme précédemment décrit, cette transformée de Fourier est dé-apodisée par la transformée de Fourier du noyau de convolution.

L'équation (1') est usuellement mise en oeuvre dans des algorithmes de gridding utilisés. Par exemple, la publication Rasche V, "Resampling of data between arbitrary grids using convolution interpolation", IEEE transactions on medical imaging, Vol. 18, N° 5, May 1999, utilise un tel produit de convolution pour redistribuer des valeurs d'une fonction de mesure selon un maillage régulier.

Il est admis que la taille du support du noyau convolution doit être réduite, de façon à limiter le temps de calcul, tout en étant suffisamment étendue pour limiter les artéfacts de reconstruction. Aussi, le support du noyau de convolution s'étend, selon chaque dimension de l'espace de départ, généralement selon 1 à 10 pas associés aux coordonnées du maillage uniforme. Par pas, on entend un intervalle entre deux coordonnées adjacentes, selon une dimension de l'espace de départ.

La convolution est réalisée en effectuant un maillage préalable unique de l'espace k, par exemple un maillage de Voronoï, sur la base duquel on détermine la densité d'échantillonnage $c(r_i)$ à chaque point de mesure $r_i$. Autrement dit, à chaque point de mesure $r_i$ correspond une valeur de densité d'échantillonnage utilisée quelle que soit la coordonnée d'interpolation $u_j$.

L'inventeur a constaté qu'un tel protocole pouvait induire un bruit, dit bruit de reconstruction, affectant l'image obtenue dans l'espace direct. L'invention propose un procédé de détermination d'un produit de convolution d'une fonction, représentant une mesure, par un noyau de convolution, par exemple préalablement à une transformée de Fourier, permettant d'améliorer la qualité des images reconstruites. De plus, ce procédé permet, dans certains cas, d'accroître la vitesse de traitement des données mesurées.

## EXPOSE DE L'INVENTION

Un objet de l'invention est un procédé d'estimation d'un produit de convolution d'une fonction de mesure par un noyau de convolution, ladite fonction de mesure étant représentative de mesures acquises par un détecteur, et définie dans un espace de départ, selon des premières coordonnées, notamment discrètes, le procédé visant à estimer une valeur dudit produit de convolution en des deuxièmes coordonnées, notamment discrètes, dudit espace de départ, le noyau de convolution étant défini sur un support, dit support de convolution (ou support d'interpolation), fini dans ledit espace de départ; le procédé comportant une acquisition de mesures par un détecteur et l'établissement de la fonction de mesure,

le procédé comportant, pour chaque deuxième coordonnée, les étapes suivantes :

a) à partir du support de convolution, définition d'un support de convolution dit centré (ou support d'interpolation centré), associé à ladite deuxième coordonnée, de telle sorte que ladite deuxième coordonnée constitue le centre dudit support de convolution centré ;

b) définition d'un maillage dans ledit support de convolution centré, de façon à associer un élément de surface à chaque première coordonnée incluse dans ledit support de convolution centré ;

c) détermination d'un facteur de pondération associé à chaque première coordonnée incluse dans ledit support de convolution centré, ce dernier étant associé à ladite deuxième coordonnée ;

d) calcul d'un produit de convolution de ladite fonction de mesure par ledit noyau sur ledit support de convolution centré, en pondérant une valeur de la fonction de mesure, à chaque première coordonnée incluse dans ledit support de convolution centré, par le facteur de pondération associé à ladite première coordonnée, déterminé lors de l'étape c) ;

e) estimation d'une valeur d'un produit de convolution à ladite deuxième coordonnée en fonction du calcul réalisé lors de l'étape d) ;

les étapes a) à e) étant mises en oeuvre, pour chaque deuxième coordonnée, par au moins un microprocesseur, le procédé étant caractérisé en ce que lors de l'étape b) le maillage est défini de telle sorte chaque élément de surface est contenu dans ledit support de convolution centré, associé à ladite deuxième coordonnée.

Ainsi, au moins deux éléments de surface, associés à une même première coordonnée, et à deux deuxièmes coordonnées distinctes, sont différents l'un de l'autre.

On notera que, contrairement à l'art antérieur, le procédé comporte une définition du maillage, propre à chaque support élémentaire centré. Par conséquent, lors du calcul du produit de convolution en deux deuxièmes coordonnées différentes, le facteur de pondération associé à une même première coordonnée peut varier, en fonction de la deuxième coordonnée considérée. Cela constitue une différence notable à l'égard de l'art antérieur.

Par fonction représentative de mesures, on entend une fonction établie à partir de mesures issues d'un détecteur, ces mesures pouvant faire l'objet d'un traitement préalable, par exemple une convolution, ou un changement d'espace par application d'un opérateur de type transformée de Fourier.

Par produit de convolution, on entend un produit de convolution discret, le noyau de convolution pouvant être une fonction continue.

Selon un mode de réalisation, lors de l'étape d), le produit de convolution comporte une somme, des produits :

- d'une valeur de la fonction de mesure à une première coordonnée ;
- d'une valeur du noyau de convolution à ladite première coordonnée référencée à la deuxième coordonnée ;
- du facteur de pondération déterminé lors de l'étape c), ce dernier étant associé à ladite première coordonnée et à ladite deuxième coordonnée ;

lesdits produits étant calculés pour chaque première coordonnée incluse dans le support de convolution centré associé à une deuxième coordonnée.

Par première coordonnée référencée à la deuxième coordonnée, on entend une différence de la deuxième coordonnée et de la première coordonnée.

Selon un mode de réalisation, le procédé peut comporter, préalablement aux étapes a) à e), l'établissement d'un maillage initial de l'espace de départ, de façon à associer, à chaque première coordonnée, un élément de surface initial, de telle sorte que dans au moins une étape b), chaque élément de surface associé à une première coordonnée est déterminé en tronquant ledit maillage initial par ledit support de convolution centré, de telle sorte que chaque élément de surface initial s'étendant au-delà dudit support de convolution centré est modifié de façon à être délimité par ledit support de convolution centré.

Selon un mode de réalisation, lors de l'étape b) le maillage dudit support de convolution centré est réalisé de telle sorte qu'au moins un élément de surface, voire chaque élément de surface, est défini indépendamment de tout maillage initial. Autrement dit, le maillage d'un support centré, associé à une deuxième coordonnée, est réalisé indépendamment du maillage d'un autre support centré, associé à une autre deuxième coordonnée. De préférence, le maillage de chaque support de convolution centré est réalisé indépendamment du maillage des autres supports de convolution centrés. L'étape b) peut alors comporter :

- une détermination, dans chaque support de convolution centré, de premières coordonnées, dites particulières, auxquelles le noyau de convolution prend une valeur particulière, par exemple une valeur nulle ;
- une définition d'éléments de surfaces, dits particuliers, associés à ces premières coordonnées particulières.

Le procédé peut comporter l'une des caractéristiques suivantes, prises individuellement ou selon les combinaisons techniquement réalisables :

- Lors de l'étape c), le facteur de pondération associé à chaque première coordonnée est déterminé en calculant une aire de l'élément de surface associé à ladite première coordonnée, défini lors de l'étape b).

- Lors de l'étape c), le facteur de pondération associé à chaque première coordonnée est déterminé en calculant une intégrale du noyau de convolution sur l'élément de surface associé à ladite première coordonnée, défini lors de l'étape b).
- Lors de l'étape c), chaque support de convolution centré est subdivisé en une pluralité de surfaces élémentaires, le calcul du facteur de pondération, associé à chaque première coordonnée comportant une somme des surfaces élémentaires comprises dans l'élément de surface associé à ladite première coordonnée, ladite somme étant éventuellement pondérée par une valeur dudit noyau de convolution dans chacune desdites surfaces élémentaires. Dans ce cas, le nombre de surfaces élémentaires dans un support de convolution centré peut être déterminé en fonction du nombre de premières coordonnées incluses dans ledit support de convolution centré, de la distance entre deux premières coordonnées adjacentes appartenant audit support de convolution centré, ou de l'évolution du noyau de convolution dans ledit support de convolution centré.
- Chaque deuxième coordonnée définit un maillage uniforme de l'espace de départ.
- L'espace de départ est un espace défini dans le domaine fréquentiel, spatial ou temporel, ou leur combinaison.
- Le microprocesseur comporte une pluralité de microprocesseurs élémentaires, les étapes a) à e) étant mises en oeuvre simultanément par différents microprocesseurs élémentaires, chaque microprocesseur élémentaire effectuant les étapes a) à e) pour une ou plusieurs deuxièmes coordonnées.
- Le noyau de convolution est une fonction symétrique par rapport au centre de son support et/ou une fonction dont la valeur est maximale au centre de son support.
- Les mesures sont issues d'un détecteur par imagerie à résonance magnétique. Il s'agit notamment de mesures d'un signal électromagnétique, dans le domaine spectral des radio-fréquences.

Un autre objet de l'invention est un support d'enregistrement d'informations, comportant des instructions pour l'exécution d'un procédé tel que décrit dans la demande, ces instructions étant aptes à être exécutées par un microprocesseur.

Un autre objet de l'invention est un procédé d'estimation d'une transformée de Fourier d'une fonction de mesures, représentative de mesures acquises par un détecteur, et définie dans un espace de départ, selon des premières coordonnées discrètes, ledit procédé comportant :

- une estimation d'un produit de convolution de ladite fonction de mesure par un noyau de convolution, tel que précédemment décrit, le produit de convolution étant estimé en une pluralité de deuxièmes coordonnées, notamment discrètes, disposées selon un maillage, par exemple uniforme, d'un l'espace de départ,
- l'application d'une transformée de Fourier rapide audit produit de convolution estimé auxdites deuxièmes coordonnées.

La transformée de Fourier ainsi estimée est définie dans un espace d'arrivée. Ce procédé peut comporter une étape de normalisation de ladite transformée de Fourier par une transformée de Fourier du noyau de convolution.

Le terme transformée de Fourier, sans autre indication, désigne une transformée de Fourier directe ou inverse. Il en est de même pour la transformée rapide de Fourier, qui désigne indifféremment une transformée directe ou inverse.

Par maillage uniforme, on entend un maillage régulier d'un espace, chaque pas de maille selon les différents axes de coordonnées étant une constante propre à chaque axe. Autrement dit, la distance, selon un axe, entre deux coordonnées adjacentes, est constante.

L'invention sera mieux comprise dans les exemples de réalisation décrits ci-après, en lien avec les figures suivantes.

**FIGURES**

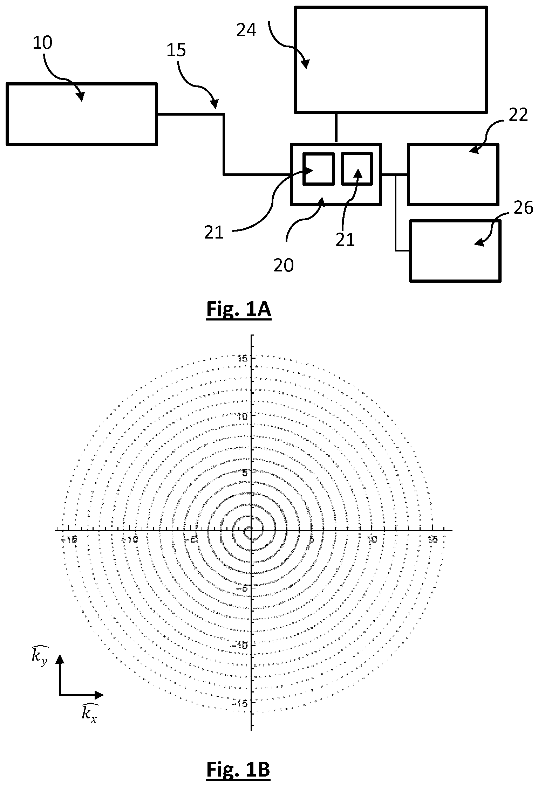

La figure 1A représente un détecteur apte à acquérir des mesures pouvant être traitées selon l'invention. La figure 1B représente une répartition des mesures, selon une spirale dans un espace de fréquences spatiales, dit espace k.

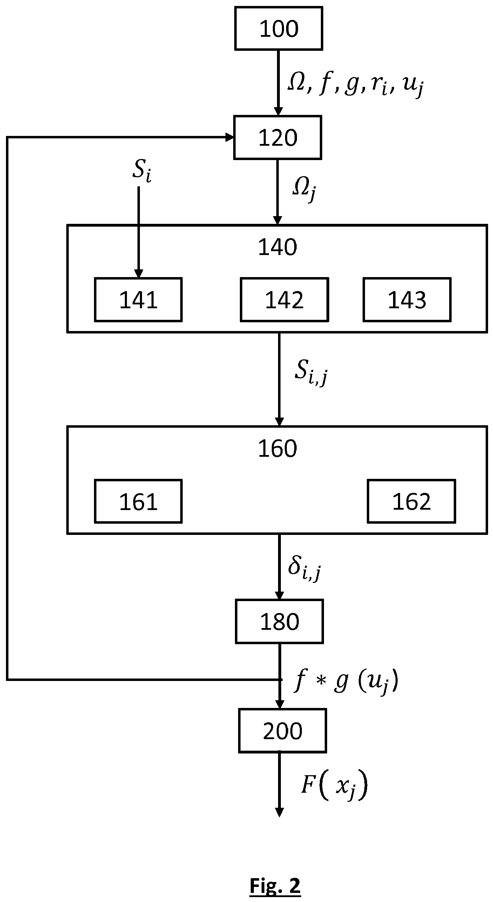

La figure 2 représente les principales étapes d'un procédé selon l'invention.

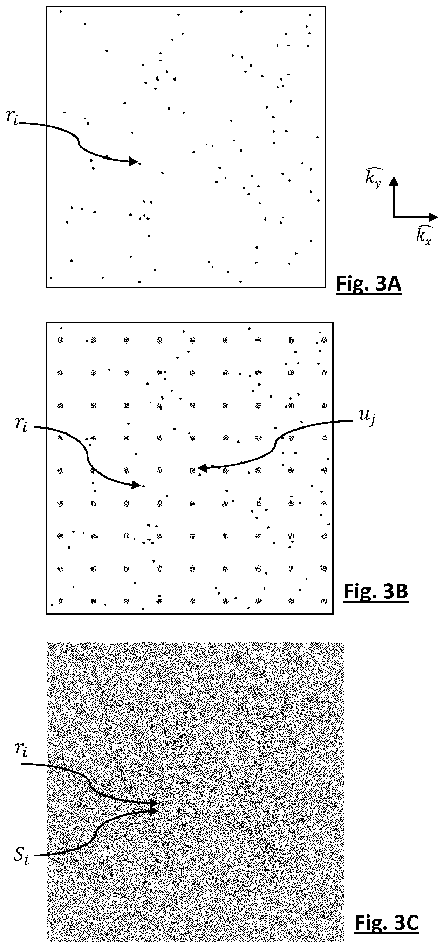

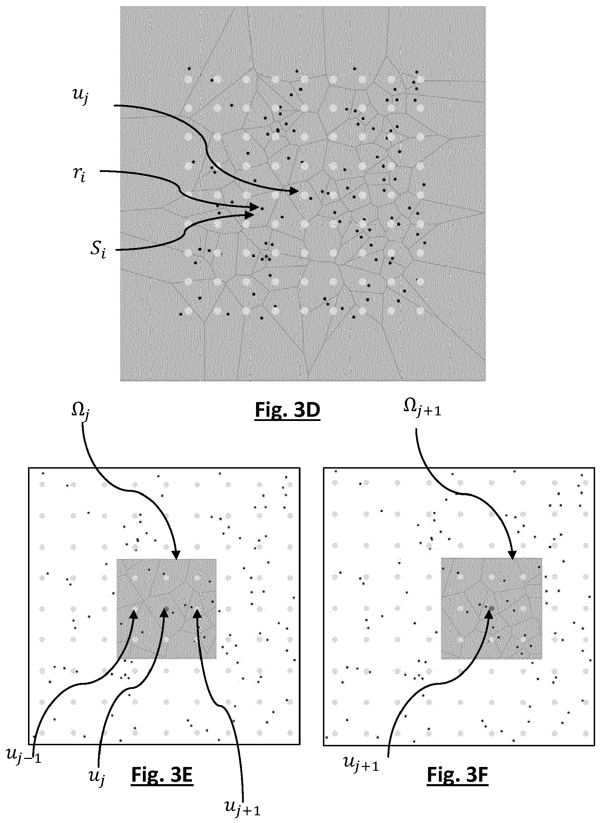

La figure 3A représente des points de mesure, ou premières coordonnées, répartis selon une répartition non uniforme, dans ledit espace k. La figure 3B représente lesdites premières coordonnées, non uniformément réparties, ainsi que des deuxièmes coordonnées, définissant une grille cartésienne. La figure 3C représente un maillage de Voronoï réalisé selon la répartition présentée sur la figure 3A. La figure 3D représente le maillage illustré sur la figure 3C, sur lequel apparaît la grille cartésienne uniforme précédemment évoquée. Les figures 3E et 3F représentent un support de convolution centré selon deux deuxièmes coordonnées voisines de la grille cartésienne.

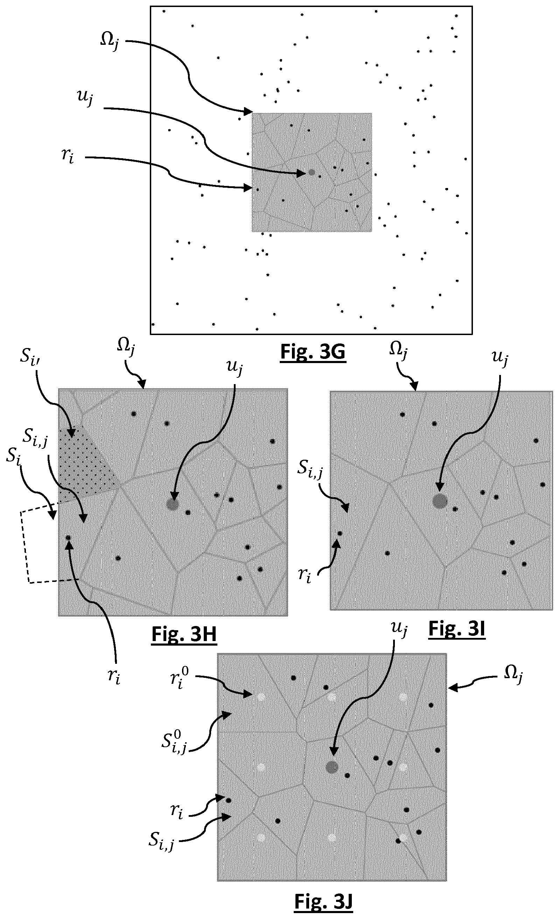

La figure 3G représente un support de convolution centré sur une deuxième coordonnée de la grille cartésienne.

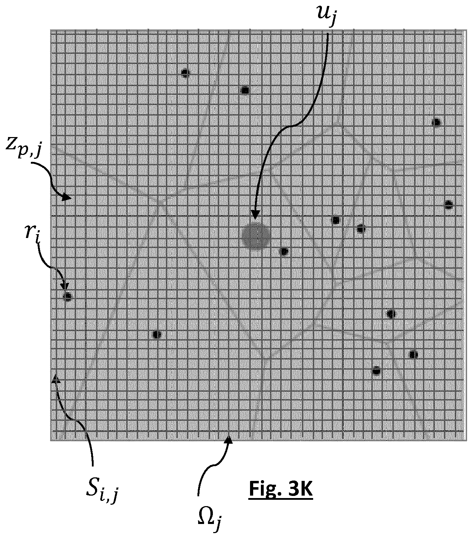

Les figures 3H, 3I et 3J illustrent trois possibilités différentes de définir un maillage du support de convolution élémentaire représenté sur la figure 3G. Ces figures représentent respectivement une première variante, une deuxième variante et une troisième variante permettant de définir ce maillage. La figure 3K représente une subdivision d'un support de convolution centré par des surfaces élémentaires.

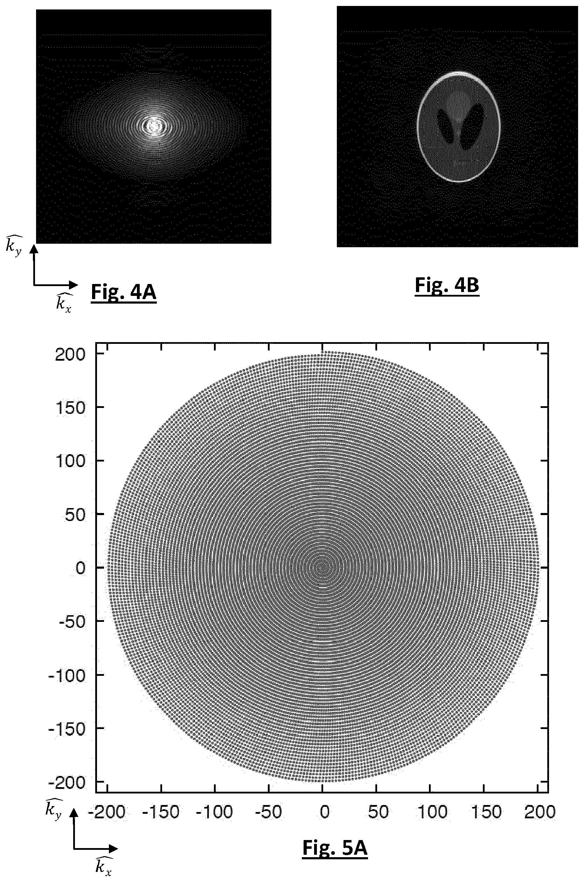

La figure 4A représente le résultat d'un produit de convolution d'une fonction de mesure par un noyau de convolution, dans un espace k, ce produit étant calculé selon un maillage uniforme de cet espace. Dans cet exemple, la fonction de mesure est obtenue pour différents points de mesure non régulièrement distribués, par une simulation d'une séquence d'acquisition IRM. La figure 4B est une représentation d'une transformée de Fourier rapide du produit de convolution illustré sur la figure 4A. Elle représente une distribution spatiale de l'aimantation nucléaire dans un objet examiné, en l'occurrence un modèle de cerveau.

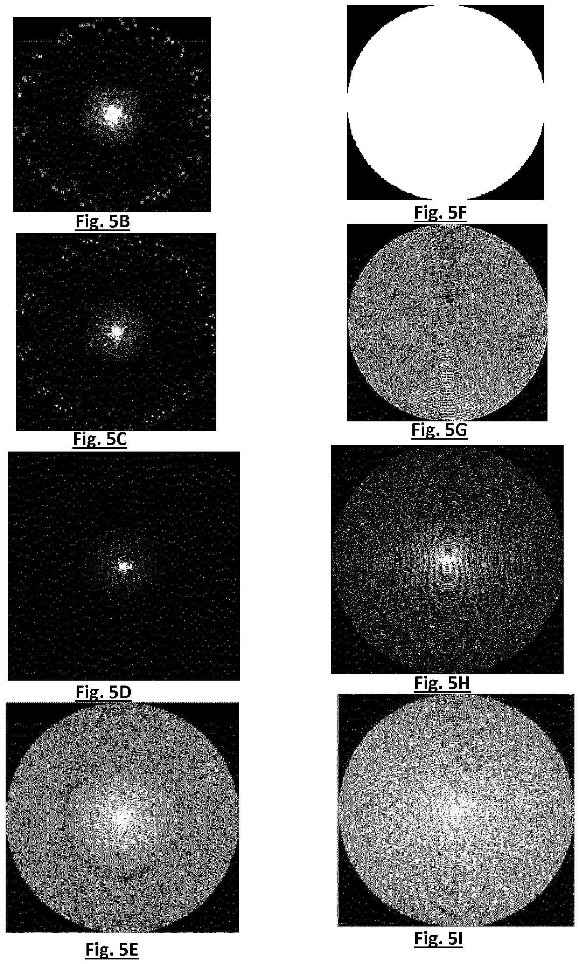

La figure 5A représente une spirale selon laquelle sont réparties des mesures selon un deuxième exemple et selon un troisième exemple. Les figures 5B, 5C, 5D et 5E sont des résultats issus du deuxième exemple, représentatif de l'art antérieur. Les figures 5F, 5G, 5H et 5J sont des résultats issus d'un troisième exemple, en mettant en oeuvre un procédé selon l'invention.

## EXPOSE DE MODES DE REALISATION PARTICULIERS

La figure 1A représente un détecteur 10 apte à acquérir des mesures 15, de façon à former une fonction de mesure $f$ représentative de ces mesures. Les mesures 15 sont transmises à une unité de traitement, tel un microprocesseur 20. Ces mesures correspondent à des grandeurs physiques mesurées, par exemple des valeurs d'un champ électromagnétique, d'un champ magnétique, d'un signal électronique, acoustique, optique, cette liste n'étant pas limitative. Le microprocesseur est relié à une mémoire 22, apte à stocker des instructions permettant la mise en oeuvre, par ledit microprocesseur, du procédé décrit ci-après, en lien avec les figures 2 et 3A à 3G. Dans les modes de réalisation décrits ci-après, le détecteur est une antenne d'un dispositif de type IRM, évoqué en lien avec l'art antérieur, apte à mesurer un signal radio-fréquentiel émis par un objet soumis à un gradient de champ magnétique. La figure 1B illustre une trajectoire, en forme de spirale, décrite en lien avec l'art antérieur, dans un espace de fréquences spatiales, dit espace k. Les points correspondent à des coordonnées selon lesquelles les mesures sont échantillonnées. Ces mesures échantillonnées sont réparties de façon non uniforme dans l'espace k. Les axes de cette figure représentent les fréquences spatiales $k_x$, $k_y$ respectivement selon deux vecteurs de base $\widehat{k_x}$ et $\widehat{k_y}$ de l'espace direct.

La figure 2 décrit les principales étapes d'un procédé selon l'invention. Selon ce procédé, on dispose de données mesurées, réparties discrètement dans un espace, dit espace de départ, selon des premières coordonnées. Il s'agit dans cet exemple de mesures réalisées par une modalité d'imagerie par résonance magnétique (IRM), ces données étant classiquement représentées dans un espace fréquentiel, dit espace k, repéré par deux vecteurs de base $\widehat{k_x}$ et $\widehat{k_y}$. Sur la figure 3A, les points noirs $r_i$ représentent de telles premières coordonnées, et on dispose de mesures $f(r_i)$ à chaque première coordonnée $r_i = (k_{x,i}; k_{y,j})$. Ces premières coordonnées ne sont pas réparties selon un maillage uniforme. Dans l'exemple représenté sur la figure 3A, ces premières coordonnées sont réparties de façon aléatoire dans l'espace de départ. On a représenté, sur cette figure, les deux vecteurs de base $\widehat{k_x}$ et $\widehat{k_y}$ de cet espace de départ. Comme évoqué en lien avec l'art antérieur, ces mesures peuvent être représentées dans un deuxième espace, dit espace d'arrivée, ou espace direct. Le passage de l'espace de départ, fréquentiel, à l'espace direct peut être réalisé par application d'une transformée de Fourier rapide aux données mesurées dans l'espace fréquentiel. Mais cela nécessite de disposer d'une distribution, dans cet espace, de données selon un maillage uniforme. Un tel maillage uniforme, ou grille cartésienne uniforme, correspond à des deuxièmes coordonnées $u_j$, représentées sur la figure 3B, aux côtés des premières coordonnées $r_i$. Le pas d'un tel maillage désigne une distance entre deux deuxièmes coordonnées adjacentes alignées selon un vecteur de base de l'espace de départ.

On cherche alors à déterminer, à chaque deuxième coordonnée $u_j$, un produit de convolution de la fonction de mesure $f$ par un noyau de convolution $g$, de façon à obtenir des données régulièrement espacées. Comme décrit en lien avec l'art antérieur, le noyau de convolution $g$ est déterminé sur un support $\Omega$. Le noyau de convolution est de préférence maximal au centre du support, et il est de préférence symétrique. Il peut s'agir typiquement de la fonction de Kaiser-Bessel mais d'autres fonctions communément utilisées pour le filtrage "passe-bas" sont possibles, comme une fonction de type $sinc$ tronquée ou une fonction prolate sphéroïdale d'ordre 0, ou la combinaison de telles fonctions. Le noyau de convolution peut être une fonction séparable, c'est-à-dire que sa valeur en un point correspond au produit des valeurs d'une fonction unidimensionnelle en chaque coordonnée de ce point.

A chaque deuxième coordonnée $u_j$, le produit de convolution peut s'exprimer selon la forme :

$$f * g\left(u_j\right) = \sum_{r_i \in \Omega_j} f(r_i)g(u_j - r_i)\,\partial_{i,j} \quad (2)$$

où $\Omega_j$ désigne le support du noyau de convolution (ou support de convolution) centré en $u_j$ et $\partial_{i,j}$ désigne un terme de pondération dépendant de la première coordonnée $r_i$ et de la deuxième coordonnée $u_j$.

Selon l'art antérieur, à chaque première coordonnée $r_i$ est attribuée une densité d'échantillonnage $c(r_i)$, et à chaque deuxième coordonnée $u_j$, on effectue le produit de convolution suivant :

$$f * g\left(u_j\right) = \sum_{r_i \in \Omega_j} f(r_i)g(u_j - r_i)\frac{1}{c(r_i)} \quad (1)',$$

le terme $\frac{1}{c(r_i)}$ correspondant également à un terme de pondération, dit densité d'échantillonnage, décrit en lien avec l'art antérieur.

L'inventeur a considéré qu'il était plus pertinent de se baser sur une hypothèse selon laquelle à chaque deuxième coordonnée $u_j$, le produit de convolution comprend un terme de pondération, noté $\partial_{i,j}$, variant non seulement en fonction de la première coordonnée $r_i$, mais également en fonction de la deuxième coordonnée $u_j$. On va justifier, dans les paragraphes suivants, le bien-fondé de cette hypothèse.

La figure 3C représente l'application d'un maillage de Voronoï à l'espace de départ. C'est sur cette base qu'on peut déterminer, selon l'art antérieur, la densité d'échantillonnage associée à chaque première coordonnée $r_i$, avec

$\frac{1}{c(r_i)} = \delta(r_i)$, où $\delta(r_i)$ décrit l'aire d'une maille, ou élément de surface $S_i$, associée à la coordonnée $r_i$.

La figure 3D représente le premier espace maillé selon un maillage de Voronoï, tel que représenté sur la figure 3C, et sur lequel apparaissent les premières coordonnées $r_i$ et les deuxièmes coordonnées $u_j$.

On suppose, dans cette figure, que le support $\Omega$ du noyau de convolution $g$ s'étend selon trois pas séparant des deuxièmes coordonnées $u_j$, selon chaque vecteur de base de l'espace de départ. Les figures 3E et 3F représentent les supports du noyau de convolution centrés des noyaux de convolution, notés $\Omega_j$ et $\Omega_{j+1}$, respectivement associés à des deuxièmes coordonnées voisines $u_j$ et $u_{j+1}$. Pour une lecture plus aisée, la figure 3G correspond à la figure 3E, sans représenter les deuxièmes coordonnées $u_{j-1}$, et $u_{j+1}$ adjacentes de la deuxième coordonnée $u_j$.

Le procédé comporte une première étape 100 de définition des données d'entrée, en particulier :

- les premières coordonnées $r_i$, définies dans cet exemple de façon non uniforme, et les valeurs $f(r_i)$ d'une fonction de mesure en chacune de ces premières coordonnées. Dans cet exemple, la fonction de mesure résulte d'un système d'acquisition de mesures par IRM, dans l'espace k.
- les deuxièmes coordonnées $u_j$, avec $1 \leq j \leq J$, j étant un entier naturel et $J$ désignant le nombre de deuxièmes coordonnées à considérer.
- le noyau de convolution $g$ et son support $\Omega$, fini dans l'espace de départ.

Connaissant les premières coordonnées $r_i$, les deuxièmes coordonnées $u_j$ ainsi que le support $\Omega$, l'étape suivante 120 du procédé revient à centrer le support $\Omega$ selon une deuxième coordonnée $u_j$, le support ainsi centré étant noté $\Omega_j$ et désigné par le terme support de convolution centré en $u_j$.

Le procédé comporte ensuite une étape 140, comportant l'attribution d'un élément de surface, noté $S_{i,j}$, à chaque première coordonnée $r_i$ du support $\Omega_j$ centré sur ladite deuxième coordonnée $u_j$. Plusieurs variantes peuvent être considérées.

Selon une première variante 141, on tire profit d'un maillage de l'espace de départ préalablement réalisé, dit maillage initial, par exemple le maillage de Voronoï représenté sur les figures 3C et 3D. Ce maillage initial permet d'attribuer, à chaque première coordonnée $r_i$, un élément de surface initial $S_i$. Comme on peut le voir sur la figure 3H, ce maillage est tronqué par le support de convolution $\Omega_j$ centré sur la deuxième coordonnée $u_j$. Chaque élément de surface initial $S_i$ s'étendant au-delà du support $\Omega_j$ est coupé et délimité par la bordure périphérique du support $\Omega_j$. On a représenté, sur la figure 3H, un élément de surface initial $S_i$ associé à une première coordonnée $r_{i'}$, ainsi tronqué. Les traits en pointillés correspondent aux limites initiales de cet élément de surface initial $S_i$, telles que représentées sur la figure 3C. Le fait de tronquer le maillage initial de l'espace de départ revient à reconfigurer ce maillage, en apposant de nouvelles limites à tout élément de surface initial $S_i$ s'étendant au-delà du support $\Omega_j$, ces nouvelles limites étant les bordures de ce dernier. Cela revient à obtenir un élément de surface $S_{i,j}$ différent de l'élément de surface initial $S_i$.

Ainsi, on a associé, à chaque première coordonnée $r_i$, un élément de surface $S_{i,j}$ contenu (ou inclus) dans le support de convolution centré $\Omega_j$. Chaque élément de surface initial $S_i$ s'étendant au-delà de la périphérie du support

de convolution centré $\Omega_j$ est tronqué de façon à constituer un élément de surface $S_{i,j}$ délimité par le support de convolution centré $\Omega_j$. On peut alors déterminer l'aire de chaque élément de surface $S_{i,j}$, à partir de laquelle on définit un facteur de pondération $\delta_{i,j}$ correspondant au couple première coordonnée $r_i$ - deuxième coordonnée $u_j$. Ce facteur de pondération $\delta_{i,j}$ peut par exemple être égal à l'aire de l'élément de surface $S_{i,j}$ auquel il est associé.

Ce mode de réalisation revient à redéfinir, à chaque deuxième coordonnée $u_j$, le maillage dans le support de convolution centré $\Omega_j$, de façon à associer, à chaque première coordonnée $r_i$, un élément de surface $S_{i,j}$ délimité par ledit support de convolution centré $\Omega_j$, et inclus dans ce dernier. Autrement dit, au cours de cette variante, le procédé comporte une adaptation du maillage initial à chaque support de convolution centré $\Omega_j$, de telle sorte que

- les éléments de surface $S_i$ du maillage initial ne s'étendant pas au-delà du support $\Omega_j$ sont conservés ;
- les éléments de surface $S_i$ du maillage initial s'étendant au-delà du support $\Omega_j$ sont tronqués, de façon à être délimités par ledit support.

La valeur du produit de convolution, à la deuxième coordonnée $u_j$ est alors calculée selon l'expression (2) :

$$f * g\left(u_j\right) = \sum_{r_i \in \Omega_j} f(r_i) \, g(u_j - r_i) \, \partial_{i,j} \qquad (2)$$

Selon l'art antérieur, cette valeur est déterminée selon l'expression (1') :

$$f * g\left(u_j\right) = \sum_{r_i \in \Omega_j} f(r_i) \, g(u_j - r_i) \, \frac{1}{c(r_i)} \qquad (1)'$$

Dans l'art antérieur, le terme de pondération $\frac{1}{c(r_i)}$ associé à une première coordonnée $r_i$ est indépendant de la deuxième coordonnée $u_j$ tandis que selon l'invention, ce terme dépend du maillage lequel est redéfini dans chaque support de convolution centré $\Omega_j$.

Le maillage décrit en lien avec cette variante présente cependant un inconvénient, lié au fait qu'un support de convolution centrée $\Omega_j$ peut comprendre des éléments de surface, issus du maillage initial, associés à des premières coordonnées $r_i$ non incluses dans ce support de convolution centré. Un tel élément de surface $S_{i'}$ est représenté, sur la figure 3H, selon une texture en pointillés. Un tel élément de surface n'est pas pris en compte dans le calcul du produit de convolution, du fait que la première coordonnée, à laquelle il est associé, n'est pas incluse dans le support de convolution $\Omega_j$. Par conséquent, entre deux deuxièmes coordonnées $u_j$ différentes, la surface du support de convolution centré effectivement prise en compte peut fluctuer.

Un autre inconvénient de cette variante est une certaine dépendance vis-à-vis du maillage initial. En effet, certains points de mesure $r_i$ peuvent être éliminés, et ceux qui restent peuvent être éventuellement complétés par d'autres points de mesure. En effet, dans certaines applications, le jeu de mesures $f(r_i)$ peut être partiellement réactualisé avec élimination d'un sous-ensemble de points $(r_i)$ et ajout d'autres points. Cela signifie que la liste des premières coordonnées $r_i$ est susceptible d'évoluer. Le fait de se baser sur un maillage initial nécessite d'ajuster ce maillage initial lors de l'élimination d'un point de mesure, ou de l'ajout d'un point de mesure. Cet ajustement peut être coûteux en temps.

Une approche plus rigoureuse est décrite ci-dessous, en lien avec une deuxième variante 142, selon laquelle chaque support de convolution centré $\Omega_j$ fait l'objet d'un maillage indépendant de tout précédent maillage. Cette variante est illustrée sur la figure 3I. A chaque première coordonnée $r_i$ incluse dans le support $\Omega_j$ correspond un élément de surface $S_{i,j}$. Un tel maillage peut être un maillage de Voronoï réalisé non pas sur l'ensemble de l'espace de départ, à l'instar du maillage initial précédemment évoqué, mais limité audit support de convolution centré $\Omega_j$ et borné par ce dernier.

Autrement dit, au cours de cette variante, le maillage de l'espace de départ est réalisé, sur chaque support de convolution centré, de façon à définir des éléments des surfaces $S_{i,j}$, formant une partition du support de convolution centré $\Omega_j$, et ne s'étendant pas au-delà de ce dernier. Le maillage d'un support de convolution centré est alors réalisé indépendamment du maillage des autres supports de convolution centrés. De façon analogue à la variante précédemment décrite, on peut alors déterminer l'aire de chaque élément de surface $S_{i,j}$ à partir de laquelle on définit un facteur de pondération $\partial_{i,j}$ correspondant au couple première coordonnée $r_i$ - deuxième coordonnée $u_j$. Ce facteur de pondération peut par exemple être égal à l'aire de l'élément de surface $S_{i,j}$ auquel il est associé. Par conséquent, entre deux deuxièmes coordonnées $u_j$ différentes, la surface du support de convolution $\Omega_j$ prise en compte dans le calcul du produit de convolution est identique.

Un avantage de cette variante est que le maillage de chaque support de convolution est effectué de manière indépendante. Les maillages respectifs de deux supports d'interpolation centrés $\Omega_j$ ne se recouvrant pas, ne s'influencent pas mutuellement. Aussi, lors de l'ajout ou de la suppression d'un point de mesure, de première coordonnée $r_i$, les maillages respectifs des supports de convolution centrés $\Omega_{j, r_i \notin \Omega_j}$ ne contenant pas le point ajouté ou supprimé peuvent être conservés. L'ajout ou la suppression d'un point de mesure $r_i$ n'entraîne donc qu'une redéfinition du maillage des quelques supports de convolution centrés $\Omega_{j, r_i \in \Omega_j}$ contenant ce point. Les facteurs de pondération $\partial_{i,j}$ ne sont recalculés que pour les supports de convolution centrés $\Omega_{j, r_i \in \Omega_j}$ contenant les points de mesure $r_i$ ajoutés ou supprimés, les facteurs de pondération $\partial_{i,j}$ associés aux autres supports $\Omega_{j, r_i}$ pouvant être conservés, sous réserve que le noyau de convolution $g$, son support $\Omega$ ou les deuxièmes coordonnées $u_j$ soient également conservés. Ainsi, lors de l'ajout ou de la suppression d'un point de mesure, seuls les supports de convolution centrés $\Omega_{j, r_i \in \Omega_j}$ contenant ledit point font l'objet d'une redéfinition de leur maillage. On comprend que l'impact d'une modification des points de mesure est limité aux seuls supports de convolution centrés contenant les points modifiés, ce qui permet de réduire le temps de calcul nécessaire à la détermination des facteurs de pondération $\partial_{i,j}$ liés à chaque élément de surface $S_{i,j}$. Le procédé permet ainsi une bonne adaptation du maillage de l'espace de départ à une évolution des premières coordonnées $r_i$.

Selon une troisième variante 143, représentée sur la figure 3J, on détermine, dans le support de convolution centré $\Omega_j$ considéré, des premières coordonnées $r_i^0$, dites particulières, auxquelles le noyau de convolution $g$ présente des propriétés particulières, par exemple une valeur nulle. On réalise alors un maillage du support de convolution centré $\Omega_j$ en associant des éléments de surface, dits particuliers, $S_{i,j}^0$ auxdites premières coordonnées particulières $r_i^0$, de la même façon que des éléments de surface $S_{i,j}$ sont associés aux premières coordonnées $r_i$ auxquelles la fonction de mesure est définie. Le maillage du support de convolution centré tient donc compte de ces éléments de surface particuliers. Cela permet une formation d'éléments de surface dans lesquels le noyau de convolution est soit strictement positif, soit strictement négatif. Autrement dit, cela permet la formation s'éléments de surface dans lesquels le noyau de convolution est de même signe.

A la suite de l'étape 140, et quelles que soient les variantes, on a établi, dans chaque support de convolution centré $\Omega_j$, un maillage, propre à chaque support élémentaire centré, permettant d'associer à chacune des premières coordonnées $r_i$ incluses dans le support de convolution centré, un élément de surface $S_{i,j}$ inclus dans le support de convolution centré et ne s'étendant pas en dehors de ce dernier.

L'étape suivante 160 consiste à établir, à chaque élément de surface $S_{i,j}$ ainsi déterminé, un facteur de pondération $\partial_{i,j}$ destiné à être utilisé dans le calcul de $f * g (u_j)$ selon l'équation (2). Il a déjà été indiqué que ce facteur de pondération $\partial_{i,j}$ dépend de l'aire de l'élément de surface $S_{i,j}$ auquel il est associé.

Selon une première variante 161, le facteur de pondération $\partial_{i,j}$ correspond à l'aire de l'élément de surface $S_{i,j}$ auquel il est associé.

Selon une deuxième variante 162, le facteur de pondération $\partial_{i,j}$ est obtenu à partir de l'intégrale du noyau de convolution $g$ sur l'élément de surface $S_{i,j}$ auquel il est associé. Autrement dit, $\partial_{i,j}$ est une estimation de $\int_{S_{i,j}} g(u_j - q) d_q / g(u_j - r_i)$. L'inventeur estime que cette variante constitue une variante préférée, dans la mesure où elle prend en compte l'évolution du noyau de convolution $g$ dans chaque élément de surface $S_{i,j}$.

Selon un mode de réalisation, représenté sur la figure 3K, lors des étapes 161 et 162, l'aire d'un l'élément de surface $S_{i,j}$ ou l'intégrale du noyau de convolution dans cet élément de surface, sont calculés en subdivisant chaque support de convolution centré en une pluralité $P_j$ de surfaces élémentaires $z_{p,j}$, avec $1 \le p \le P_j$. Le calcul du facteur de pondération $\partial_{i,j}$ comporte alors :

- une sommation desdites surfaces élémentaires $z_{p,j}$ présentes dans l'élément de surface, ce qui permet une estimation de l'aire de ce dernier : $\partial_{i,j} = \sum_{z_{p,j} \in S_{i,j}} z_{p,j}$ (3)
- ou une sommation desdites surfaces élémentaires $z_{p,j}$ présentes dans l'élément de surface pondérées par une valeur dudit noyau de convolution $g$ dans chaque surface élémentaire :

$$\partial_{i,j} = \frac{\sum_{z_{p,j} \in S_{i,j}} z_{p,j} \times g(z_{p,j})}{g(u_j - r_i)} \quad .$$

Avantageusement, le nombre $P_j$ de surfaces élémentaires $z_{p,j}$ constituant un support de convolution centré $\Omega_j$ dépend du nombre de premières coordonnées $r_i$ incluses dans ledit support. Plus ce nombre est élevé, plus le nombre $P_j$ est important, ce qui diminue d'autant la taille de ces surfaces élémentaires. Inversement, lorsque le support de convolution centré $\Omega_j$ comporte peu de premières coordonnées $r_i$, par exemple à la périphérie d'une spirale formée dans l'espace k, le nombre de surfaces élémentaires constituant chaque support de convolution centré est plus faible, et la taille de ces surfaces élémentaires est plus importante. Cela permet d'optimiser le temps de calcul.

Lorsque deux premières coordonnées $r_i$, $r_i'$ sont situées dans une même surface élémentaire $z_{p,j}$, elles peuvent être fusionnées pour ne constituer qu'une seule coordonnée, à laquelle on attribue une valeur moyenne de la fonction de mesure $f(r_i)$, $f(r_i')$ de chaque coordonnée fusionnée.

La subdivision de chaque support élémentaire centré $\Omega_j$ peut ne pas être uniforme et être adaptée à l'évolution de la valeur du noyau $g(z_{p,j})$ dans ledit support élémentaire centré. La subdivision peut être plus fine dans les parties du support élémentaire dans lesquelles le noyau connaît une évolution rapide, les surfaces élémentaires $z_{p,j}$ étant alors plus petites que dans d'autres parties du support, dans lesquelles l'évolution de la valeur du noyau est plus lente.

La subdivision de chaque support élémentaire centré $\Omega_j$ peut également dépendre de la distance entre deux premières coordonnées $r_i$, $r'_i$ adjacentes, appartenant à ce support. Plus ces premières coordonnées sont rapprochées, plus la subdivision est fine, les surfaces élémentaires $z_{p,j}$ étant plus petites que dans d'autres parties du support.

L'étape suivante 180 consiste à déterminer une valeur du produit de convolution $f * g$ à chaque coordonnée $u_j$ considérée, en appliquant l'expression (2).

Les étapes 120 à 180 sont répétées pour l'ensemble des deuxièmes coordonnées $u_j$, de façon à obtenir une valeur du produit de convolution $f * g\ (u_j)$ à chacune de ces coordonnées.

On a ainsi déterminé le produit de convolution de $f * g$ selon un maillage uniforme, ce qui peut constituer une étape préalable au calcul d'une transformée de Fourier rapide. Cela constitue l'étape 200 :

$$F\left( x_j \right) = FFT\left[ f * g\ (u_j) \right],\ (4)$$

où $x_j$ désigne une coordonnée dans un espace dit d'arrivée, et *FFT* désigne l'opérateur « transformée de Fourier rapide ». Dans cet exemple, où l'espace de départ est un espace fréquentiel (fréquences spatiales), l'espace d'arrivée est un espace représentant des coordonnées spatiales, ou espace direct.

Cette étape peut comporter une normalisation par la transformée de Fourier du noyau de convolution, une telle normalisation étant fréquemment désignée par le terme dé-apodisation. Cette transformée de Fourier du noyau de convolution peut être évaluée en $x_j$ par une expression analytique de cette tranformée de Fourier, ou par transformée de Fourier numérique rapide (FFT) d'échantillons de $g$ selon les deuxièmes coordonnées

$$u_j : F\left( x_j \right) = \frac{FFT\left[ f*g\ (u_j) \right]}{FFT\left[ g\ (u_j) \right]}\ (4')$$

Le procédé décrit ci-dessus peut être mis en oeuvre par un calculateur électronique, par exemple un microprocesseur 20 représenté dans la figure 1A, recevant des données mesurées 15 d'un détecteur 10. Le microprocesseur est avantageusement relié à une unité de stockage 26 et/ou à une unité d'affichage 24, permettant un affichage des données calculées, qu'il s'agisse

- de la fonction de mesure $f(r_i)$, représentant des données mesurées en chaque première coordonnée $r_i$ ;
- des produits de convolution calculés en chaque deuxième coordonnée $f * g\ (u_j)$;
- de la fonction $F(x_j)$ obtenue dans l'espace d'arrivée.

Selon un mode de réalisation avantageux, le microprocesseur comporte plusieurs microprocesseurs élémentaires 21, aptes à réaliser des opérations de calculs en parallèle, de préférence simultanément. Le procédé décrit ci-dessus peut alors être mis en oeuvre par différents microprocesseurs élémentaires, chaque microprocesseur réalisant, par exemple, tout ou partie des étapes 100 à 200 précédemment décrites pour une ou plusieurs deuxièmes coordonnées $u_j$.

Premier exemple

Une série de simulations numériques a été réalisée, basée sur le modèle fréquentiel du fantôme de Shepp-Logan. Ce fantôme est une représentation du cerveau humain faisant apparaître les ventricules, le crâne, et différentes zones contrastées. A partir d'une expression analytique de la représentation fréquentielle du fantôme de Shepp Logan, on a simulé des mesures réparties de façon non uniforme dans un espace k, puis on a appliqué le procédé précédemment décrit, selon la deuxième variante 142, afin d'estimer le produit de convolution de chaque mesure avec un noyau de convolution, ce dernier étant une fonction *sinc* tronquée au troisième zéro. L'estimation du produit de convolution est obtenue selon une matrice uniforme de 256 * 256 deuxièmes coordonnées $u_j$ dans l'espace k. Le noyau de convolution s'étend selon 8 pas de deuxièmes coordonnées $u_j$ adjacentes dans chaque dimension de l'espace k.

La figure 4A représente une estimation du produit de convolution selon ladite matrice uniforme. L'origine de l'espace k correspond au centre de l'image et cet espace est repéré par deux vecteurs orthogonaux $\widehat{k_x}$ et $\widehat{k_y}$.

La figure 4B représente une image obtenue après application d'une transformée de Fourier rapide du produit de convolution calculé à chaque deuxième coordonnée. La zone centrale de l'image, s'étendant sur 128 * 128 pixels autour du centre de l'image, correspond à une représentation du fantôme de Shepp Logan.

Deuxième et troisième exemples

La figure 5A représente des points échantillonnés selon une spirale, chaque point de cette spirale représente une première coordonnée $r_i$ à laquelle une fonction de mesure $f(r_i)$ est définie. La fonction de mesure $f$ correspond au modèle fréquentiel du fantôme de Shepp Logan sur chaque point $r_i$ de la spirale. Selon un deuxième exemple et un troisième exemple, on a déterminé un produit de convolution $f * g\,(u_j)$, selon des coordonnées régulières $u_j$, respectivement sans mettre en oeuvre l'invention et en mettant en oeuvre l'invention. Les coordonnées régulières $u_j$ correspondent à des coordonnées entières du repère représenté sur la figure 5A. Le noyau de convolution $g$ est une fonction de Kaiser Bessel séparable de largeur 4 et de facteur β égal à 8.996 selon chacun des axes du repère. Le support du noyau de convolution centré $\Omega_j$ s'étend selon 4 coordonnées entières selon chaque axe.
Dans le deuxième exemple, le produit de convolution a été calculé selon l'expression (1') préalablement décrite :

$$f * g\,(u_j) = \sum_{r_i \in \Omega_j} \frac{f(r_i)\,g(u_j - r_i)}{c(r_i)} \text{ avec } \frac{1}{c(r_i)} \approx \; \delta(r_i) \text{ le facteur de pondération correspondant à la coordonnée}$$

$r_i$ étant l'aire de l'élément de surface $S_i$ issu du maillage de Voronoï. Dans cet exemple, on se base sur un maillage de Voronoï unique de l'espace de départ, le facteur de pondération $\delta(r_i)$ associé à une première coordonnée $r_i$ étant indépendant de la deuxième coordonnée $u_j$.
Les figures 5B, 5C, 5D représentent respectivement, pour chaque coordonnée $u_j$ :

- $\sum_{r_i \in \Omega_j} \partial_i$
- $\sum_{r_i \in \Omega_j} g(u_j - r_i)\partial_i$
- $\sum_{r_i \in \Omega_j} f(r_i)g(u_j - r_i)\partial_i$

La figure 5E correspond à la figure 5D, les niveaux de gris étant représentés selon une échelle logarithmique.
Dans le troisième exemple, le produit de convolution a été calculé selon l'expression (2), selon la deuxième variante, préalablement décrite, du procédé selon l'invention. Selon ce mode de réalisation, chaque support de convolution élémentaire centré $\Omega_j$ fait l'objet d'un maillage qui lui est propre, de telle sorte que facteur de pondération $\partial_{i,j}$ associé à chaque première coordonnée $r_i$ varie en fonction de la surface élémentaire $S_{i,j}$ associée à ladite première coordonnée, dans le support de convolution centré $\Omega_j$ sur la deuxième coordonnée $u_j$. Les figures 5F, 5G, 5H représentent respectivement, pour chaque coordonnée $u_j$ :

- $\sum_{r_i \in \Omega_j} \partial_{i,j}$
- $\sum_{r_i \in \Omega_j} g(u_j - r_i)\partial_{i,j}$
- $\sum_{r_i \in \Omega_j} f(r_i)g(u_j - r_i)\partial_{i,j}$

La figure 5J correspond à la figure 5H, les niveaux de gris étant représentés selon une échelle logarithmique.
Les figures 5B et 5F montrent respectivement, pour chaque coordonnée $u_j$, la somme des facteurs de pondération pris en compte dans chaque support de convolution centré $\Omega_j$ sans et avec mise en oeuvre de l'invention. Il s'agit ici de la somme des surfaces élémentaires ($S_i$ dans le deuxième exemple et $S_{i,j}$ dans le troisième exemple) prises en compte lors du calcul de chaque produit de convolution. On observe que selon l'invention (figure 5F), cette surface peut être considérée comme constante (moyenne de 16.3 et déviation standard de 0.014), tandis qu'elle fluctue lorsqu'on ne met pas en oeuvre l'invention (figure 5B : moyenne de 50.11 - déviation standard de 156). Le fait que la moyenne soit égale à 16.3 et non à 16 provient du fait que le maillage de chaque élément de surface est réalisé en admettant une légère marge au-delà du support du noyau de convolution, pour prendre en compte d'éventuelles premières coordonnées disposées à la frontière du support du noyau de convolution.
Les figures 5C et 5G montrent respectivement la somme des facteurs de pondérations pris en compte dans chaque support de convolution centré $\Omega_j$, multipliés par les valeurs du noyau de convolution à la deuxième coordonnée $u_j$ référencée à chaque première coordonnée $r_i$ du support de convolution centré $\Omega_j$, sans et avec mise en oeuvre de l'invention. Les valeurs peuvent être considérées comme stables lorsqu'on met en oeuvre l'invention (figure 5G), la moyenne étant de 2.96 avec une déviation standard de 0.87. En revanche, les résultats sont très fluctuants sans mise en oeuvre de l'invention (figure 5C : moyenne de 8.5 - déviation standard 30.8)
Les figures 5D et 5H représentent respectivement les produits de convolution calculés, en chaque deuxième coordonnée $u_j$, sans et avec mise en oeuvre de l'invention. On observe que la figure 5H comporte davantage d'information exploitable, notamment aux fréquences spatiales élevées, ce qui permet d'obtenir une reconstruction de meilleure qualité. La figure 5E apparaît également plus bruitée que la figure 5I. Or, c'est à partir de tels produits de convolution qu'on applique une transformée de Fourier de façon à obtenir une représentation de l'image dans l'espace direct. L'obtention d'une image présentant moins de bruit permet également une reconstruction de meilleure qualité.

Dans les exemples de réalisation qui précèdent, le procédé s'applique à des mesures $f(r_i)$ réparties de façon non uniforme dans un espace fréquentiel. Il permet d'obtenir une représentation des mesures, dans un espace d'arrivée, dans le domaine spatial, par application d'une transformée de Fourier. L'homme du métier comprendra que le procédé peut s'appliquer lorsque l'espace de départ correspond au domaine spatial (ou temporel), l'espace d'arrivée étant un espace fréquentiel.

Par ailleurs, dans ces exemples de réalisation, les premières coordonnées $r_i$ sont distribuées de façon non uniforme, tandis que les deuxièmes coordonnées $u_j$ sont distribuées selon une grille cartésienne uniforme. Ces conditions correspondent au cas particulier du traitement de données $f(r_i)$ acquises par une séquence d'acquisition de type IRM. Mais l'invention peut s'appliquer dès lors qu'on souhaite estimer la valeur d'un produit de convolution $f * g$ d'une fonction $f(r_i)$, représentant des mesures, et déterminée selon des premières coordonnées $r_i$, ladite valeur étant estimée en des deuxièmes coordonnées $u_j$ différentes desdites premières coordonnées $r_i$. Les premières coordonnées $r_i$ et/ou les deuxiè-mes coordonnées $u_j$ peuvent être réparties, de façon uniforme ou non.

Un exemple d'application est une opération réciproque de celle décrite en lien avec l'exemple précédent, selon laquelle on dispose des valeurs, en des premières coordonnées $x_j$ d'un espace de départ représentant le domaine spatial, d'une fonction $F(x_j)$ représentant des mesures. Cette fonction est par exemple une représentation d'une coupe d'un objet, tel que celle décrite en lien avec la figure 4B. L'objectif est alors d'obtenir une estimation de mesures, correspondant à cette fonction $F(x_j)$, dans un espace fréquentiel, selon des premières coordonnées $r_i$, réparties de manière non uniforme, précédemment décrites.

Pour cela, on procède selon les étapes suivantes :

- normalisation par la transformée de Fourier du noyau de convolution ;
- calcul d'une transformée de Fourier rapide de la fonction F($x_j$), ce qui permet d'estimer une fonction de mesure $f(u_j)$ dans l'espace fréquentiel, selon des premières $u_j$ définissant une grille cartésienne uniforme dans cet espace fréquentiel ;
- application du procédé tel que précédemment décrit, de façon à estimer un produit de convolution $f * g (r_i)$ en des deuxièmes coordonnées $r_i$ non uniformément réparties ;

Au-delà des applications dans le traitement de données acquises par IRM, l'invention pourra s'appliquer à des données physiques mesurées à l'aide de détecteurs, ces données représentant des grandeurs physiques, en particulier des ondes électromagnétiques, un champ magnétique, un signal électrique, des ondes acoustiques.

**Revendications**

1. Procédé de traitement d'une fonction de mesure ($f$), la fonction de mesure étant représentative de mesures acquises par un détecteur (10), la fonction de mesure étant définie dans un espace de départ, selon des premières coordonnées ($r_i$), le procédé comportant l'estimation, en des deuxièmes coordonnées ($u_j$) dudit espace de départ, d'une valeur d'un produit de convolution ($f * g$) de la fonction de mesure ($f$) par un noyau de convolution (g), le noyau de convolution étant défini sur un support, dit support de convolution ($\Omega$), le procédé comportant :

- une acquisition de mesures (15) par un détecteur (10) ;
- l'établissement de la fonction de mesure ($f$), selon des premières coordonnées ($r_i$) de l'espace de départ à partir des mesures (15) issues du détecteur (10);
- la définition de deuxièmes coordonnées dans l'espace de départ ($u_j$);
le procédé comportant, pour chaque deuxième coordonnée ($u_j$), les étapes suivantes :

a) à partir du support de convolution ($\Omega$), définition d'un support de convolution dit centré ($\Omega_j$), associé à ladite deuxième coordonnée ($u_j$), de telle sorte que ladite deuxième coordonnée ($u_j$) constitue le centre dudit support de convolution centré ($\Omega_j$) ;
b) définition d'un maillage dudit support de convolution centré ($\Omega_j$), de façon à associer un élément de surface ($S_{i,j}$) à chaque première coordonnée ($r_i$) incluse dans ledit support de convolution centré ($\Omega_j$) ;
c) détermination d'un facteur de pondération ($\partial_{i,j}$) associé à chaque première coordonnée ($r_i$) incluse dans le support de convolution centré ($\Omega_j$) ;
d) calcul d'un produit de convolution de ladite fonction de mesure ($f$) par ledit noyau de convolution (g) selon le support de convolution centré ($\Omega_j$), en pondérant une valeur $f(r_i)$ de la fonction de mesure, à chaque première coordonnée ($r_i$) incluse dans ledit support de convolution centré ($\Omega_j$), par le facteur de pondération ($\partial_{i,j}$) associé à ladite première coordonnée ($r_i$), déterminé lors de l'étape c) ;
e) estimation d'une valeur dudit produit de convolution ($f * g (u_j)$) à ladite deuxième coordonnée ($u_j$) en

fonction du calcul réalisé lors de l'étape d) ;

les étapes a) à e) étant mises en oeuvre, pour chaque deuxième coordonnée ($u_j$), par au moins un microprocesseur (21),

le procédé étant **caractérisé en ce que** lors de l'étape b), le maillage est défini de telle sorte que chaque élément de surface ($S_{i,j}$) est contenu dans le support de convolution centré ($\Omega_j$), de telle sorte que le facteur de pondération ($\partial_{i,j}$) associé à une même première coordonnée ($r_i$) peut varier en fonction de la deuxième coordonnée ($u_j$).

2. Procédé selon la revendication 1, dans lequel lors de l'étape d), le produit de convolution comprend une somme des produits :

- d'une valeur $f(r_i)$ de la fonction de mesure à une première coordonnée ($r_i$)
- d'une valeur ($g$ ($u_j - r_i$)) du noyau de convolution à ladite première coordonnée référencée à la deuxième coordonnée ;
- du facteur de pondération ($\partial_{i,j}$) déterminé lors de l'étape c), ce dernier étant associé à ladite première coordonnée ($r_i$) et à la dite deuxième coordonnée ($u_j$) ;

lesdits produits étant calculés pour chaque première coordonnée ($r_i$) incluse dans le support de convolution centré ($\Omega_j$) associé à une deuxième coordonnée ($u_j$).

3. Procédé selon l'une quelconque des revendications précédentes, comportant, préalablement aux étapes a) à e), l'établissement d'un maillage initial de l'espace de départ, de façon à associer, à chaque première coordonnée ($r_i$), un élément de surface initial ($S_i$), et dans lequel lors d'au moins une étape b), chaque élément de surface ($S_{i,j}$) associé à une première coordonnée ($r_i$) est déterminé en tronquant ledit maillage initial par ledit support de convolution centré ($\Omega_j$), de telle sorte que chaque élément de surface initial ($S_i$) s'étendant au-delà dudit support de convolution centré est modifié de façon à être délimité par ledit support de convolution centré.

4. Procédé selon l'une quelconque des revendications 1 à 3, dans lequel lors d'au moins une étape b) le maillage dudit support de convolution centré est réalisé de telle sorte qu'au moins un élément de surface ($S_{i,j}$) est défini indépendamment de tout maillage initial.

5. Procédé selon la revendication 4, dans lequel ladite étape b) comporte :

- une détermination, dans ledit support de convolution centré ($\Omega_j$), de premières coordonnées $\left(r_i^0\right)$, dites particulières, auxquelles le noyau de convolution ($g$) prend une valeur particulière ;
- une définition d'éléments de surfaces, dits particuliers, $\left(S_{i,j}^0\right)$ associés à ces premières coordonnées particulières.

6. Procédé selon l'une quelconque des revendications précédentes, dans lequel lors de l'étape c), le facteur de pondération (($\partial_{i,j}$)associé à chaque première coordonnée ($r_i$) est déterminé en calculant une aire de l'élément de surface ($S_{i,j}$) associé à ladite première coordonnée ($r_i$), défini lors de l'étape b).

7. Procédé selon l'une quelconque des revendications 1 à 6, dans lequel lors de l'étape c), le facteur de pondération ($\partial_{i,j}$) associé à chaque coordonnée ($r_i$) est déterminé en calculant une intégrale du noyau de convolution ($g$) sur l'aire élément de surface ($S_{i,j}$) associé à ladite première coordonnée ($r_i$).

8. Procédé selon l'une quelconque des revendications précédentes, dans lequel lors de l'étape c), chaque support de convolution centré ($\Omega_j$) est subdivisé en une pluralité de surfaces élémentaires ($z_{p,j}$), le calcul du facteur de pondération ($\partial_{i,j}$) associé à chaque première coordonnée ($r_i$) comportant une somme des surfaces élémentaires ($z_{p,j}$) comprises dans l'élément de surface ($S_{i,j}$) associé à ladite première coordonnée ($r_i$), ladite somme étant éventuellement pondérée par une valeur dudit noyau de convolution ($g$), dans chacune desdites surfaces élémentaires.

9. Procédé selon la revendication 8, dans lequel le nombre ($P_j$) de surfaces élémentaires ($z_{p,j}$) dans un support de convolution centré ($\Omega_j$) est déterminé en fonction :

- du nombre de premières coordonnées ($r_i$) incluses dans ledit support de convolution centré ($\Omega_j$),

- ou de la distance entre deux premières coordonnées ($r_i, r'_i$) adjacentes appartenant audit support de convolution centré
- ou de l'évolution du noyau de convolution ($g$) dans ledit support de convolution centré.

10. Procédé selon l'une quelconque des revendications précédentes, dans lequel chaque deuxième coordonnée ($u_j$) définit un maillage uniforme de l'espace de départ.

11. Procédé selon l'une quelconque des revendications précédentes, dans lequel ledit microprocesseur (20) comporte une pluralité de microprocesseurs élémentaires (21), et dans lequel les étapes a) à e) sont mises en oeuvre simultanément par différents microprocesseurs élémentaires, chaque microprocesseur élémentaire effectuant les étapes a) à e) pour une ou plusieurs deuxièmes coordonnées ($u_j$).

12. Procédé selon l'une quelconque des revendications précédentes, dans lequel le noyau de convolution ($g$) est :

   - une fonction symétrique par rapport au centre de son support ($\Omega$) ;
   - et/ou une fonction dont la valeur est maximale au centre de son support ($\Omega$).

13. Procédé selon l'une quelconque des revendications précédentes, dans lequel les mesures, sur la base desquelles est établie la fonction de mesure ($f$), sont acquises par un détecteur d'ondes électromagnétiques d'un système d'imagerie par résonance magnétique.

14. Procédé d'estimation d'une transformée de Fourier d'une fonction de mesure ($f$) représentative de mesures acquises par un détecteur (10), et définie dans un espace de départ, selon des premières coordonnées discrètes ($r_i$), le dit procédé comportant :

   - une estimation d'un produit de convolution ($f * g$) de ladite fonction de mesure ($f$), par un noyau de convolution (g), selon l'une quelconque des revendications 1 à 13, en des deuxièmes coordonnées discrètes ($u_j$), ces dernières définissant un maillage dudit espace de départ ;
   - l'application d'une transformée de Fourier rapide audit produit de convolution estimé ($f * g$) auxdites deuxièmes coordonnées discrètes ($u_j$).

15. Support d'enregistrement d'informations, comportant des instructions pour l'exécution des étapes a) à e) d'un procédé selon l'une quelconque des revendications 1 à 14, ces instructions étant aptes à être exécutées par un microprocesseur (20).

**Fig. 1A**

**Fig. 1B**

$\Omega, f, g, r_i, u_j$

$S_i$

$\Omega_j$

$S_{i,j}$

$\delta_{i,j}$

$f * g\,(u_j)$

$F(x_j)$

**Fig. 2**

$r_i$

$\widehat{k_y}$

$\widehat{k_x}$

**Fig. 3A**

$r_i$

$u_j$

**Fig. 3B**

$r_i$

$S_i$

**Fig. 3C**

$u_j$

$r_i$

$S_i$

**Fig. 3D**

$\Omega_j$

$\Omega_{j+1}$

$u_{j-1}$

$u_j$    **Fig. 3E**

$u_{j+1}$

$u_{j+1}$    **Fig. 3F**

$\Omega_j$

$u_j$

$r_i$

**Fig. 3G**

$S_{i'}$

$\Omega_j$

$u_j$

$S_{i,j}$

$S_i$

$r_i$

$r_i$

**Fig. 3H**

$\Omega_j$

$u_j$

$S_{i,j}$

$r_i$

**Fig. 3I**

$u_j$

$r_i^0$

$\Omega_j$

$S_{i,j}^0$

$r_i$

$S_{i,j}$

**Fig. 3J**

**Fig. 3K**

$\widehat{k_y}$

$\widehat{k_x}$

**Fig. 4A**

**Fig. 4B**

$\widehat{k_y}$

$\widehat{k_x}$

**Fig. 5A**

Fig. 5B

Fig. 5C

Fig. 5D

Fig. 5E

Fig. 5F

Fig. 5G

Fig. 5H

Fig. 5I

Europäisches
Patentamt

European
Patent Office

Office européen
des brevets

**RAPPORT DE RECHERCHE EUROPEENNE**

Numéro de la demande

EP 16 19 6447

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | RASCHE * V ET AL: "Resampling of Data Between Arbitrary Grids Using Convolution Interpolation", IEEE TRANSACTIONS ON MEDICAL IMAGING, IEEE SERVICE CENTER, PISCATAWAY, NJ, US, vol. 18, no. 5, 1 mai 1999 (1999-05-01), XP011035860, ISSN: 0278-0062 sec. I, II; * abrégé; figure 4 * ----- | 1-15 | INV. G06F17/15 G01R33/36 |
| A | SCHOMBERG H ET AL: "THE GRIDDING METHOD FOR IMAGE RECONSTRUCTION BY FOURIER TRANSFORMATION", IEEE TRANSACTIONS ON MEDICAL IMAGING, IEEE SERVICE CENTER, PISCATAWAY, NJ, US, vol. 14, no. 3, 1 septembre 1995 (1995-09-01), pages 596-607, XP000527221, ISSN: 0278-0062, DOI: 10.1109/42.414625 * pages 596, 604 * ----- | 1-15 | |

DOMAINES TECHNIQUES RECHERCHES (IPC)

G06F
G01R

Le présent rapport a été établi pour toutes les revendications

| Lieu de la recherche | Date d'achèvement de la recherche | Examinateur |
|---|---|---|
| Berlin | 6 décembre 2016 | Virnik, Elena |

EPO FORM 1503 03.82 (P04C02)

**RÉFÉRENCES CITÉES DANS LA DESCRIPTION**

**Littérature non-brevet citée dans la description**

- **RASCHE V.** Resampling of data between arbitrary grids using convolution interpolation. *IEEE transactions on medical imaging,* Mai 1999, vol. 18 (5